# DEMANDE DE BREVET EUROPEEN

(11) **EP 1 326 287 A1**
(43) Date de publication de la demande: **09.07.2003**
(21) Numéro de dépôt: 02293235.4
(22) Date de dépôt: 24.12.2002
(51) Int. Cl.: H01L 31/052

(54) **Dispositif concentrateur d'energie solaire pour vehicule spatial et panneau generateur solaire**

(30) Priorité: 07.01.2002 FR 0200127
(71) Demandeur: ALCATEL, 75008 Paris (FR)
(72) Inventeur: Tur, Myriam, 06210 Mandelieu La Napoule (FR); Dargent, Thierry, 06810 Auribeau sur Siagne (FR); Brosse, Sylvie, 83600 Les Adrets de l'Esterel (FR)
(74) Mandataire: Smith, Bradford Lee

(57) **Abrégé**

L'invention concerne un dispositif permettant de réduire les risques de décharges électrostatiques primaires etsecondaires survenant en particulier sur les générateurs solaires de véhicules spatiaux.

L'invention concerne un dispositif concentrateur d'énergie solaire pour véhicule spatial, comprenant au moins un réflecteur (12) pour la réflexion du rayonnement (16) solaire sur au moins une cellule (14) photovoltaïque destinée à la transformation de l'énergie solaire en énergie électrique.

Selon l'invention, le dispositif comprend des moyens (23,24,25) de transport thermique aptes à transporter l'énergie calorifique emmagasinée par la cellule suite à la réception du rayonnement solaire vers une zone froide (22).

Application particulière aux panneaux solaires pour satellites.

## Description

La présente invention est relative, d'une manière générale, au domaine des réseaux de concentrateurs d'énergie solaire, notamment pour applications spatiales. Elle concerne plus particulièrement un dispositif de concentrateurs d'énergie à cellules solaires.

Les panneaux générateurs solaires transportés dans un véhicule spatial, tel qu'un satellite géostationnaire, comprennent en général :
- des panneaux support d'un réseau de cellules photovoltaïques identiques ou différentes, transformant l'énergie solaire en énergie électrique ;
- un réseau de cellules solaires identiques ou différentes formant des chaînes de cellules ("strings" en anglais) et connectées électriquement, recouvrant la surface du panneau support.

De tels panneaux générateurs solaires peuvent être répartis selon des configurations très diverses. Il s'agit classiquement d'une succession longitudinale, parallèle à une direction s'éloignant du corps du véhicule spatial et autour de laquelle le générateur est destiné à tourner pour suivre le soleil. Toutefois, pour augmenter la puissance électrique disponible, il a été proposé de disposer, en plus des panneaux précédents, des panneaux supplémentaires latéraux. On connaît aussi des configurations dans lesquelles les panneaux sont disposés selon une direction transversale, c'est à dire selon une direction transversale à la direction longitudinale précitée selon laquelle s'étend l'étrier ou bras d'éloignement ("yoke" en anglais) qui relie le générateur au corps du véhicule spatial, et autour de laquelle le générateur est adapté à tourner pour suivre le soleil.

Les réseaux de concentrateurs d'énergie du type mentionné ci-dessus sont par exemple décrits dans les documents US 6,188,012 et WO 00/79593 A1.

Cependant, des anomalies correspondant à des pertes de sections de panneaux solaires ont été observées sur ce type de réseaux.

L'analyse de l'environnement et des tests au sol ont montré que l'environnement spatial pouvait engendrer des phénomènes de charges et de décharges électrostatiques au niveau des panneaux. Des analyses complémentaires et des tests ont démontré qu'une décharge électrostatique entre une cellule solaire d'un panneau et sa paroi supérieure de protection (dite "coverglass" en anglais) peut amener un court circuit entre cette cellule et une cellule adjacente, entraînant la circulation du courant utile du générateur solaire entre ces cellules. L'énergie véhiculée par ce courant est alors suffisante pour pyrolyser le substrat isolant de support des cellules (généralement du kapton™) et le rendre conducteur.

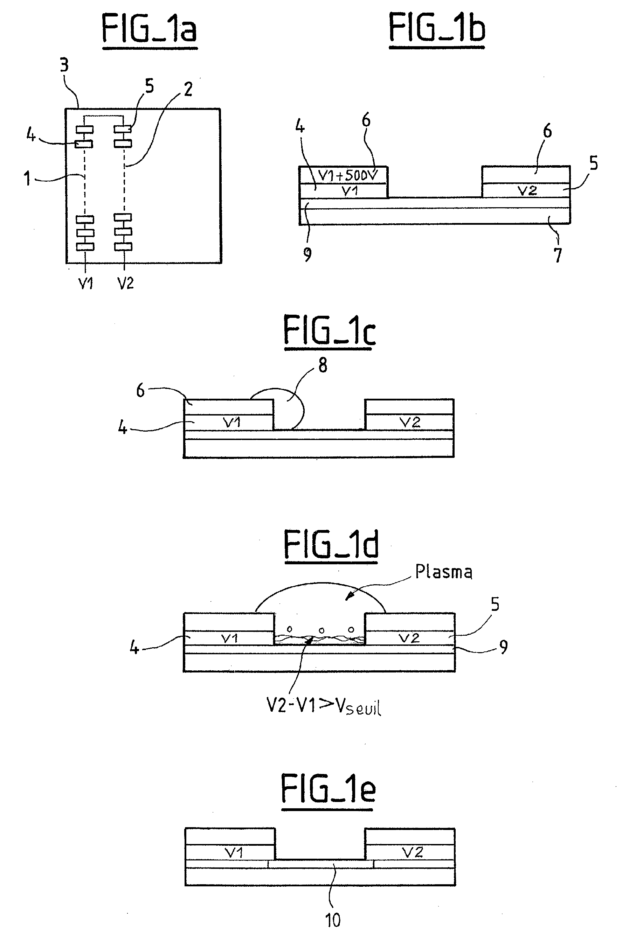

Plus précisément, le scénario conduisant aux anomalies observées se déroule selon les étapes suivantes, en référence aux figures 1.a à 1.e :
- la figure 1.a représente grossièrement deux rangées 1, 2 de cellules d'un panneau 3 générateur solaire. Chacune des rangées comportent un nombre prédéterminé de cellules 4, 5 solaires et la tension aux bornes de chaque rangée est respectivement de V1 et de V2 volts.
- en référence à la figure 1.b, due à l'environnement spatial, une situation de charge appelée gradient de tension inversé ou IVG (pour "Inverted Voltage Gradient" en anglais) apparaît entre la cellule solaire (par exemple la cellule 4) connectée à la masse électrique du satellite, et sa paroi 6 supérieure de protection qui la recouvre. En raison du processus de photo-émission, cette paroi supérieure de protection est chargée moins négativement que le châssis 7 (face arrière du panneau, donc à l'ombre) auquel est connectée la cellule.
- lorsque la tension entre la cellule solaire 4 et la paroi 6 dépasse un certain seuil, une décharge électrostatique dite primaire apparaît et génère un plasma 8 dense, tel que représenté sur la figure 1.c. Cette décharge contient peu d'énergie et est en soi sans risque pour le fonctionnement du générateur solaire. Le plasma ainsi créé se propage dans l'intervalle entre les cellules adjacentes.
- cependant, si la tension entre ces cellules est plus élevée qu'un certain seuil Vseuil, le courant utile de la rangée peut alors circuler entre les cellules via le plasma. Cet arc (arc secondaire) entretenu par le courant utile du générateur peut être maintenu pendant quelques secondes ou plus, comme illustré sur la figure 1.d.
- il apparaît alors que cet arc secondaire dissipe suffisamment d'énergie pour chauffer le substrat 9 isolant, et ce jusqu'à une température telle que le polymère de résistance élevée se transforme en matériau de très faible résistance. Ce processus de pyrolyse rend la partie 10, noircie sur la figure, complètement conductrice, ce qui entraîne un court circuit permanent entre les deux cellules 4 et 5, et donc entre les deux rangées de cellules 1 et 2, tel que représenté sur la figure 1.e, et également entre la cellule (4 ou 5) et la masse électrique du satellite, ce qui cause la destruction permanente d'une partie du générateur solaire, incapable de délivrer toute la puissance utile aux équipements du satellite.

Une méthode pour réduire les risques de décharge primaire consiste à rajouter des surfaces électriquement conductrices sur la face éclairée du générateur solaire et connectées à la masse électrique du satellite. De plus, une méthode pour réduire les risques de décharge secondaire entre rangées adjacentes résiderait dans l'augmentation de l'intervalle entre rangées de cellules photovoltaïques. Toutefois, l'espace ainsi créé entraînerait une diminution du taux de remplissage du panneau en cellules et grèverait alors la puissance collectrice d'énergie solaire du panneau.

La présente invention a pour but de remédier aux problèmes ci-dessus en proposant donc un dispositif concentrateur d'énergie à cellules solaires pour véhicule spatial, du type présenté ci-dessus, qui permette la diminution du risque de décharges électrostatiques primaires et secondaires.

A cet effet, l'invention a pour objet un dispositif de concentrateurs d'énergie solaire pour véhicule spatial, comprenant au moins un réflecteur pour la réflexion du rayonnement solaire sur au moins une cellule photovoltaïque destinée à la transformation de l'énergie solaire en énergie électrique, caractérisé en ce que le dispositif comprend des moyens de transport thermique aptes à transporter l'énergie calorifique emmagasinée par la cellule suite à la réception du rayonnement solaire vers une zone froide.

Selon un mode de réalisation de l'invention, lesdits moyens de transport thermique relient un premier panneau en contact avec la cellule à la zone froide.

Selon un mode de réalisation de l'invention, lesdits moyens de transport thermique comportent un système de transport capillaire de la chaleur.

Selon un mode de réalisation de l'invention, lesdits moyens de transport thermique comprennent au moins un micro-caloduc comportant un matériau caloporteur.

Selon un mode de réalisation de l'invention, les moyens de transport thermique comprennent un diélectrique thermiquement conducteur destiné à diminuer le gradient thermique dans le dispositif.

Selon un mode de réalisation de l'invention, le réflecteur comprend une paroi externe adaptée pour offrir une propriété absorptive dans la gamme de fréquences infrarouges de manière à émettre sous forme de rayonnement infrarouge la chaleur emmagasinée suite à la réception du rayonnement solaire, et adaptée pour offrir une propriété réflexive dans la gamme des fréquences de lumière visible. La paroi interne possède des propriétés émissives de la chaleur pour évacuer celle-ci vers le vide spatial.

Selon un mode de réalisation de l'invention, ledit dispositif comporte également des moyens électriquement conducteurs reliant ladite paroi externe du réflecteur avec la masse électrique du panneau (qui est, en général, la structure électrique du véhicule spatial).

Selon un mode de réalisation de l'invention, lesdits moyens de transport thermique sont intégrés au panneau de support de ladite cellule.

Selon un mode de réalisation de l'invention, la paroi externe du réflecteur est recouverte d'un revêtement apte à réfléchir la lumière visible, par exemple suite au dépôt d'un film d'aluminium et sa paroi interne est recouverte d'un revêtement de forte émissivité, par exemple d'une peinture noire.

Selon un mode de réalisation de l'invention, la base du réflecteur en un matériau électriquement conducteur et à haut rendement de réflectivité du spectre visible est située à une distance minimum de déclenchement de décharge électrostatique par rapport aux extrémités de la cellule solaire.

Selon un mode de réalisation de l'invention, cette distance est de 0,8 mm.

L'invention a également pour objet un panneau générateur solaire, caractérisé en ce qu'il comporte un dispositif concentrateur d'énergie solaire selon l'invention.

Selon un mode de réalisation de l'invention, ledit panneau comprend une pluralité de réflecteurs pour la réflexion du rayonnement solaire sur une pluralité correspondante de chaînes de cellules, les réflecteurs et les chaînes de cellules étant placés alternativement, chaque chaîne de cellules étant alignée selon la largeur du panneau.

D'autres caractéristiques et avantages de l'invention apparaîtront plus clairement à la lecture de la description suivante des exemples particuliers de réalisation en référence aux figures suivantes :
- les figures 1.a à 1.e, déjà décrites, représentent deux rangées de cellules solaires de l'état de la technique, et plus particulièrement le processus de détérioration qu'elles peuvent subir suite à des décharges primaires et secondaires,
- la figure 2a représente schématiquement une vue en perspective d'une portion de panneau de générateur solaire,
- la figure 2b illustre le parcours de rayons lumineux reçus par le générateur solaire, à savoir d'une part des rayons lumineux directs et d'autre part des rayons réfléchis par les réflecteurs,
- la figure 3 illustre une coupe schématique selon une section partielle transversale du panneau de la figure 2,
- la figure 4 représente une coupe partielle d'un panneau muni d'un dispositif de concentrateurs d'énergie solaire selon un mode de réalisation de l'invention,
- la figure 5 représente un réflecteur,
- la figure 6 représente des modes de réalisation d'intégration de panneaux centraux et latéraux comportant des panneaux concentrateurs selon l'invention,
- la figure 7a représente des parois de réflecteurs en regard d'une cellule solaire soumis à une concavité représentée par une double flèche,
- La figure 7b représente l'évolution du facteur de concentration en fonction de l'angle d'incidence pour une configuration donnée,
- La figure 7c montre l'impact de la concavité des réflecteurs sur le facteur de concentration optique C_{optique},
- La figure 7d montre l'effet conjoint de la concavité et de l'angle d'incidence des réflecteurs sur le facteur de concentration optique C_{optique},
- La figure 7e montre la sensibilité du facteur de concentration optique C_{optique} en fonction de l'angle d'incidence relié lui-même à la concavité,
- La figure 8 représente la température sous la cellule solaire et sous les réflecteurs démontrant ainsi l'existence d'un gradient thermique dans la structure du panneau solaire.

Sur les figures suivantes, des éléments remplissant des fonctions identiques porteront les mêmes références.

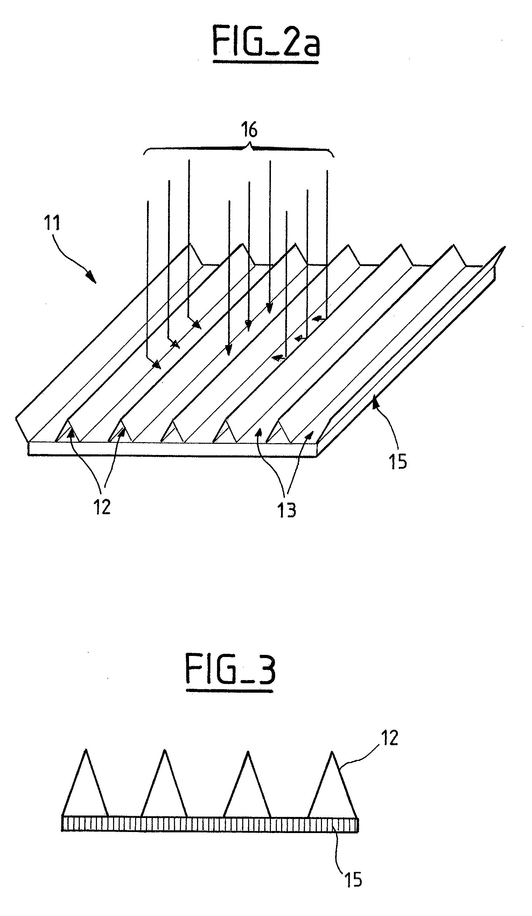

Sur la figure 2a, il est représenté, schématiquement, une vue en perspective d'un panneau 11 de générateur solaire.

Ce panneau 11 présente, sur sa face destinée à être orientée vers la source lumineuse, une succession alternée de réflecteurs 12 et de chaînes 13 de cellules 14 solaires. On note que, dans ce mode de réalisation des réflecteurs, ceux-ci ont été choisis selon une configuration en dents de scie. Bien entendu, il peut être envisagé toute autre forme de réflecteurs, du type parabolique ou autres. Les réflecteurs et les cellules sont supportés par un panneau 15 support.

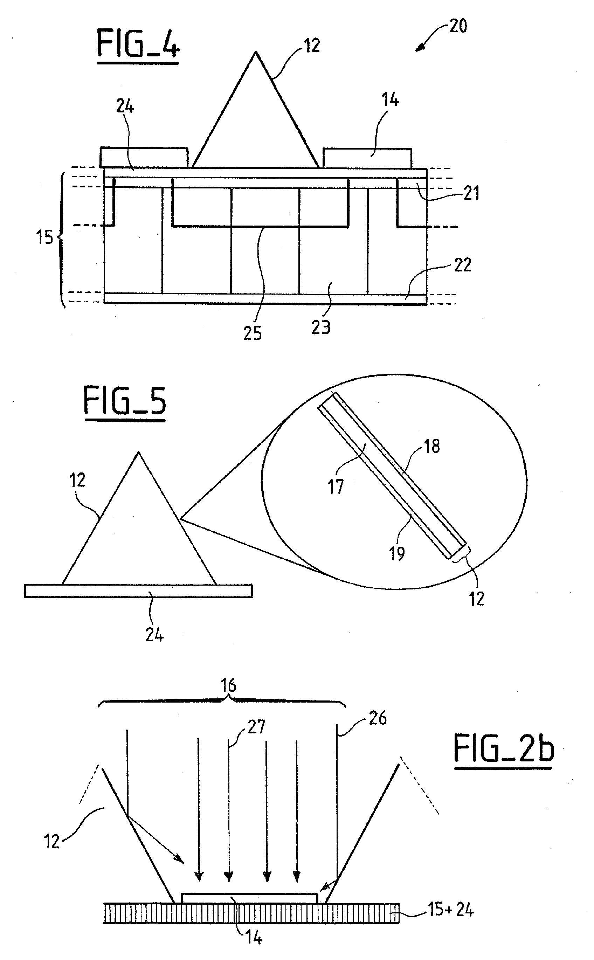

Sur les figures 2a et 2b, est représenté, sous forme de plusieurs flèches, un flux solaire 16 dont certains faisceaux 27 illuminent directement la cellule 14 alors que d'autres 26 atteignent la cellule suite à une réflexion sur un réflecteur.

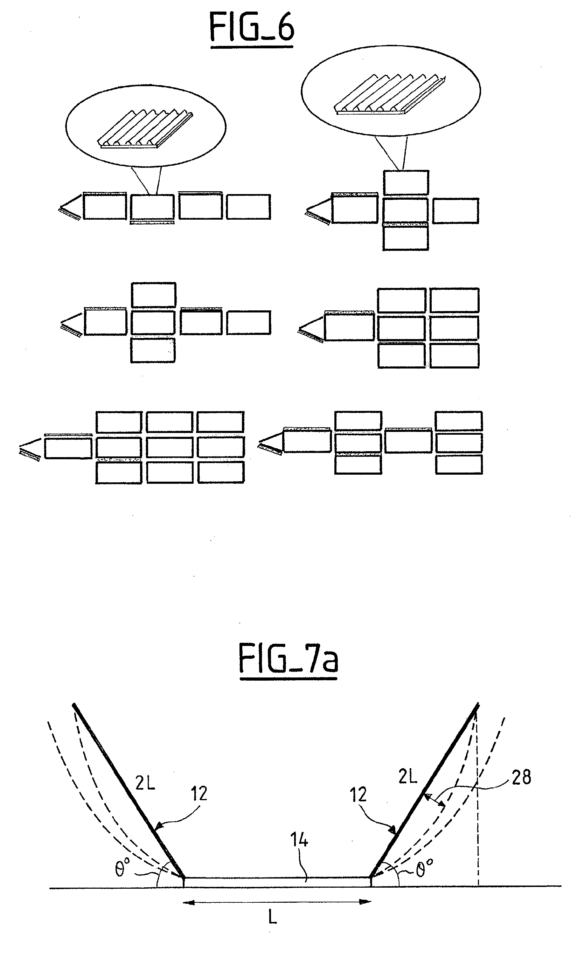

En outre, on notera sur la figure 2a et la figure 6 (décrite ci-dessous) que les cellules et réflecteurs sont agencés suivant la largeur des panneaux, ceci afin de minimiser une éventuelle pénalité sur le bilan de puissance dans le cas où une antenne ou autre appendice vient ombrer le panneau. Bien entendu, les cellules et réflecteurs peuvent également être agencés selon la longueur des panneaux qui les supportent.

La figure 3 illustre une coupe selon une section transversale du panneau de la figure 2a. L'avantage d'une telle configuration réside dans la diminution des effets de distorsion des réflecteurs sur la puissance fourni par le panneau solaire car il s'agit ici d'une concentration locale et non sur un panneau complet. Cela se traduit par un meilleur facteur de concentration.

Dans le cas de la présente invention, le facteur de concentration Cgeometrique est fonction de l'angle θ d'inclinaison des réflecteurs par rapport au plan du panneau de support, ceci selon la relation :

Cgéométrique = 1+2sin(2θ-90°).
La limite théorique de ce facteur est : Cgéométrique = 3.

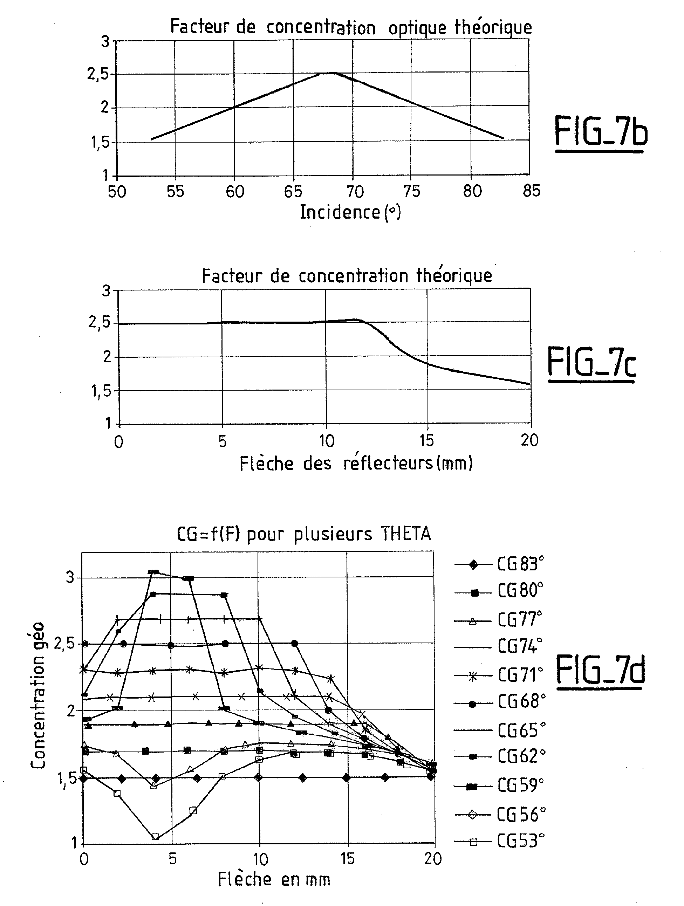

Dans le cas pratique où, les réflecteurs ont une longueur 2L par rapport à la cellule 14 de dimension L, tel que représenté sur la figure 7a,, le facteur optique théorique obtenu par la méthode du « Ray-tracing », atteint un optimum égal à 2,5 pour une incidence correspondant à θ=68°, tel que l'on peut le constater sur la figure 7b illustrant le facteur de concentration optique théorique en fonction de l'incidence θ. Ceci présuppose que le rendement de réflectivité des réflecteurs soit de R=1 et que les réflecteurs soint parfaitement plans. La figure 7c représente l'effet de la présence d'une courbure ou concavité, illustré par une double flèche 28 (figure 7a) s'exerçant sur une paroi de réflecteur. La dimension d'une telle flèche correspond à la distance entre la position plane du réflecteur et sa position courbée. Une double flèche de plus de 10mm contribue à une diminutaion brutale du facteur de concentration optique.

Toute concavité des réflecteurs entraine une variation des angles d'incidence des réflecteurs. Dans le cas initial pratique de C_{optique} =2,5, la figure 7d montre la variation du facteur de concentration pour différentes longueurs de flèches et par conséquent différents angles d'incidence.On s'aperçoit que l'optimum se situe pour des flèches voisines de 4mm (C_{optique} >3 et supérieur au facteur de concentration initial 2,5). En fait, lorsque l'inclinaison des réflecteurs diminue, la surface vue par le soleil de ces réflecteurs augmente et l'énergie potentielle reçue augmente. Dans le cas de réflecteurs plans, cette énergie n'est pas renvoyée vers la cellule mais lorsqu' ils présentent une courbure, cette énergie peut être renvoyée sur la cellule et ainsi augmenter le facteur de concentration.

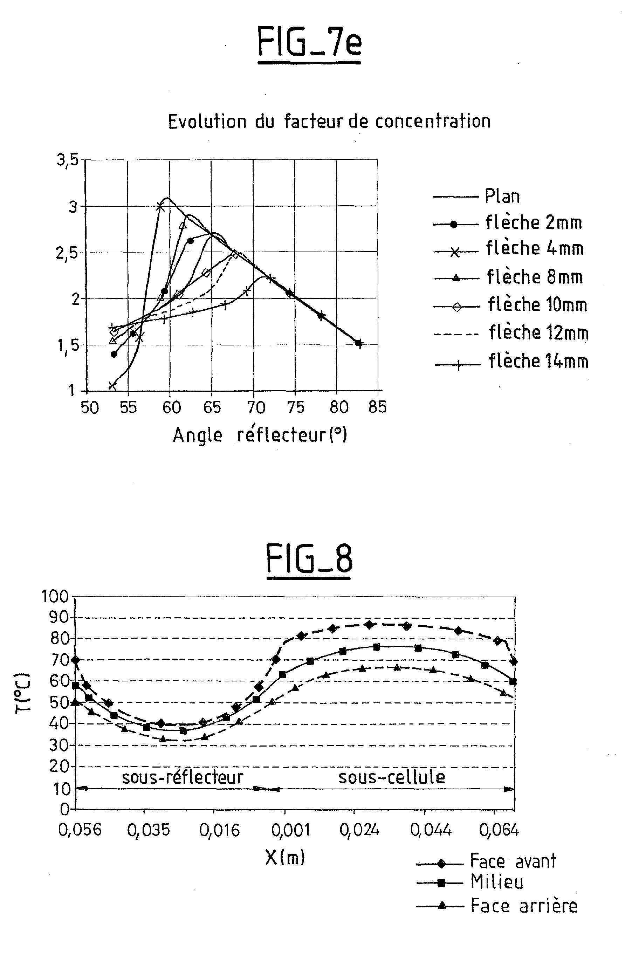

Pour une flèche de 4mm , C_{optique} peut devenir supérieur au C_{optique} initial mais devient très sensible à l'angle d'incidence θ comme montré sur la figure 7e.

Le facteur de concentration optique dépend du rendement R optique du matériau réfléchissant soit: C_{optique} = 1+R(C_{optique R=1}-1). Par exemple, pour R=1, C_{optique} =2.5 et pour R=0.88, C_{optique} = 2.32.

Typiquement, pour avoir un facteur de concentration optique stable à 10%, il faut une stabilité d'incidence de ± 4° et une flèche inférieure à 12mm.

La figure 4 représente une coupe du panneau 11 muni d'un dispositif 20 de concentrateur d'énergie solaire selon un mode de réalisation de l'invention. Dans cette vue, il y est illustré un réflecteur 12, détaillé à la figure 5 selon deux vues, pour lequel un traitement de surface adapté sur ses parois interne et externe a été réalisé. Ce réflecteur est constitué d'un film 17 de plusieurs dizaines de micromètres de Kapton™ ou Upilex™ ou autre matériau ayant de très bonnes propriétés mécanique et thermique pour satisfaire les exigences thermique et mécanique de l'environnement spatial (entrées/sorties d'éclipses, pression solaire, oxygène atomique, UV, ...). Ce film 17 est recouvert, par déposition électrochimique, d'un film 18 optiquement réfléchissant, par exemple de l'Aluminium (ou autre matériau déposé optiquement très réfléchissant dans le visible et électriquement conducteur). Le film 18 est adapté pour offrir une propriété absorbante dans la gamme de fréquences infrarouges de manière à absorber sous forme de rayonnement infrarouge la chaleur emmagasinée suite à la réception du rayonnement solaire, et adapté pour offrir une propriété optique de réflexion dans la gamme des fréquences de la lumière visible. La paroi interne 19 est donc destinée à évacuer sous forme d'émission de chaleur dans le vide spatial. Celle-ci peut être un dépôt de peinture noire. Ces deux traitements de surface sont effectués sur le support film 17 mince. Dans cet exemple de réalisation, un dépot d'Aluminium sur la paroi externe du réflecteur permet d'avoir une émissivité dans l'infrarouge de 0,3. A cela, la face interne du réflecteur est recouverte d'une peinture noire à forte émissivité dans l'infrarouge. Ces dispositions ont été judicieusement apportées car, dans l'espace en raison de la micropesanteur, il ne peut y avoir de convection et la température du panneau générateur solaire est uniquement pilotée par les échanges conductifs et radiatifs avec l'environnement.

A la figure 4, le panneau support 15 des cellules et réflecteurs comporte deux semelles identiques 21 et 22 en fibres de carbone prenant en sandwich une structure 23 alvéolaire en aluminium, usuellement dénommée "NiDa" pour "Nid D'Abeille". La semelle 21 est recouverte d'un film diélectrique 24 (Kapton®, Upilex®, ou tout autre matériau électriquement isolant mais à forte conductivité thermique) prévenant ainsi tout court-circuit des cellules solaires. La structure NiDa 23 présente des propriétés mécaniques exceptionnelles avec les semelles 21 et 22, et présente une bonne conductivité thermique transversale (inhérent à la configuration en NiDa en aluminium). Pour augmenter l'efficacité de transport de chaleur dans le plan longitudinal du panneau (c'est à dire selon le plan du panneau 15) et diminuer de façon conséquente le gradient thermique inhérent au concept (hautes températures sous les cellules et basses températures sous les réflecteurs, cf figure 8), des microcaloducs 25, véhiculant un matériau caloporteur, tel que de l'ammoniac ou de l'eau, relient une première cellule 14 d'une première chaîne 13 à une seconde cellule 14 en regard appartenant à une chaîne 13 adjacente. De la sorte, la chaleur provenant des zones chaudes correspondant aux zones porteuses des cellules est transmise par les micro-caloducs 25, en complément du film diélectrique et thermiquement conducteur situé directement sous les cellules solaires (Kapton, Upilex, ...). Ces micro-caloducs véhiculent l'énergie calorifique vers une masse thermique que sont les zones froides du panneau 15, à savoir, d'une part les zones sous les réflecteurs 12 et, d'autre part, la semelle 22 de dissipation thermique vers lequel la chaleur est véhiculée de manière transversale au moyen des alvéoles conductrices en aluminium.

L'utilisation des micro-caloducs vient en complément de l'utilisation du film 24 qui permet d'homogénéiser la température entre les zones chaudes sous les cellules et les zones froides sous les réflecteurs. Par cette triple utilisation {micro-caloducs; film thermique ; structure alvéolaire NiDa}, sous l'effet de la concentration solaire et donc sous l'effet de la concentration des rayons IR réfléchis par les réflecteurs 12 et absorbés par les cellules, le gradient thermique dans la structure porteuse 15 est fortement minimisé. On comprend ainsi que l'invention permet, par l'utilisation de réflecteurs 12 revêtus d'un film 18 non seulement optiquement réfléchissant et surtout électriquement conducteur de diminuer les risques de décharges électrostatiques.

L'Aluminium étant électriquement conducteur et les réflecteurs étant placés sur la face éclairée du panneau solaire, la photo-émission permet de réduire la quantité de charge stockée dans la structure (masse électrique du satellite). Le potentiel de la structure est alors moins négatif. Le risque de décharge électrostatique dite primaire diminue. Pour cela, il est indispensable que le revêtement des réflecteurs soit conducteur et qu'il soit électriquement connecté à la masse du satellite (parties conductrices de la structure).

L'avantage de l'invention résulte également dans le fait que le plasma généré par la décharge primaire ne peut pas se propager entre cellules adjacentes, les réflecteurs faisant office d'écran. De plus, ce concept permet d'augmenter la distance entre le site émissif et la cellule solaire adjacente lors d'une décharge secondaire. La distance entre cellules solaires (intervalle de l'ordre de 0.8 mm) est ramenée à la distance entre le réflecteur (site émissif dans ce cas) et la cellule adjacente; cette distance pouvant être de quelques millimètres. La tension seuil entre cellules au-dessus de laquelle un arc secondaire apparaît augmente, ce qui diminue le risque d'arc secondaire. En fait, pour ces réflecteurs, l'utilisation d'un revêtement électriquement conducteur et électriquement connecté à la masse électrique du panneau permet de diminuer les risques de décharge électrostatique dite primaire et le risque d'arc secondaire.

Bien entendu, l'invention n'est pas limitée aux modes de réalisation décrits dans la présente demande.

## Revendications

1. Dispositif concentrateur d'énergie solaire pour véhicule spatial, comprenant au moins un réflecteur (12) pour la réflexion du rayonnement (16) solaire sur au moins une cellule (14) photovoltaïque destinée à la transformation de l'énergie solaire en énergie électrique,
**caractérisé en ce que** le dispositif comprend des moyens (23,24,25) de transport thermique aptes à transporter l'énergie calorifique emmagasinée par la cellule suite à la réception du rayonnement solaire vers une zone froide (22).

2. Dispositif selon la revendication 1, **caractérisé en ce que** lesdits moyens de transport thermique comportent un système (25) de transport capillaire de la chaleur.

3. Dispositif selon l'une des revendications 1 à 2, **caractérisé en ce que** lesdits moyens de transport thermique comportent des moyens longitudinaux (25) reliant la base de ladite cellule à une seconde cellule du dispositif.

4. Dispositif selon l'une des revendications 1 à 3, **caractérisé en ce que** lesdits moyens de transport thermique comprennent au moins un micro-caloduc (25) comportant un matériau caloporteur.

5. Dispositif selon l'une des revendications 1 à 4, **caractérisé en ce que** les moyens de transport thermique comprennent un diélectrique (24) thermiquement conducteur destiné à diminuer le gradient thermique dans le dispositif.

6. Dispositif selon l'une des revendications 1 à 5, **caractérisé en ce que** le réflecteur comprend une paroi externe (18) électriquement conductrice et adaptée pour offrir une propriété d'absorptivité optique dans la gamme de fréquences infrarouges de manière à absorber sous forme de rayonnement infrarouge la chaleur emmagasinée suite à la réception du rayonnement solaire et adaptée pour offrir une propriété de réflexion du rayonnement solaire dans la gamme des fréquences de la lumière visible, et un dépôt (19) résultant d'un traitement de surface en vue de l'amélioration de l'efficacité radiative de la chaleur vers le vide spatial.

7. Dispositif selon l'une des revendications 1 à 6, **caractérisé en ce que** ladite paroi externe (18) du réflecteur est électriquement reliée à la masse électrique du panneau.

8. Dispositif selon la revendication 7, **caractérisé en ce que** lesdits moyens de transport thermique et/ou les moyens électriquement conducteurs sont intégrés au panneau de support (15) de ladit cellule.

9. Dispositif selon la revendication 3, **caractérisé en ce que** le système de transport capillaire de la chaleur est formé de micro-caloducs.

10. Dispositif selon l'une des revendications 1 à 9, **caractérisé en ce que** la base du réflecteur en un matériau électriquement conducteur et à haut rendement de réflectivité du spectre visible est située à une distance minimum de déclenchement de décharge électrostatique par rapport aux extrémités de la cellule solaire.

11. Dispositif selon la revendication 10, **caractérisé en ce que** cette distance est de 0,8 mm.

12. Panneau générateur solaire, **caractérisé en ce qu'**il comporte un dispositif concentrateur d'énergie solaire selon l'une des revendications 1 à 11.

13. Panneau selon la revendication 12, **caractérisé en ce que** ledit dispositif comprend une pluralité de réflecteurs (12) pour la réflexion du rayonnement solaire sur une pluralité correspondante de chaînes (13) de cellules, les réflecteurs et les chaînes de cellules étant alternativement agencés, chaque chaîne de cellules étant alignée selon la largeur ou la longueur du panneau.
